# EUROPÄISCHE PATENTSCHRIFT

(11) **EP 0 637 062 B1**
(45) Veröffentlichungstag und Bekanntmachung des Hinweises auf die Patenterteilung: **04.06.1997**
(21) Anmeldenummer: 94109666.1
(22) Anmeldetag: 22.06.1994
(51) Int. Cl.: H01L 21/306, H01L 21/3105, H01L 21/76

(54) **Verfahren zur Herstellung eines Halbleiterschichtaufbaus mit planarisierter Oberfläche und dessen Verwendung bei der Herstellung eines Bipolartransistors sowie eines DRAM**
Process for manufacturing semi-conducteur device with planarized surface and application to the manufacturing of bipolar transistors and DRAM
Procédé pour la fabrication de dispositif à semi-conducteur ayant une surface planarisée et application pour la fabrication de transistors bipolaires et de DRAM

(30) Priorität: 27.07.1993 DE 4325188
(43) Veröffentlichungstag der Anmeldung: 01.02.1995
(73) Patentinhaber: SIEMENS AKTIENGESELLSCHAFT, 80333 München (DE)
(72) Erfinder: Meister, Thomas, Dr., D-82024 Taufkirchen (DE); Stengl, Reinhard, Dr., D-86391 Stadtbergen (DE)

(56) Entgegenhaltungen:
- PATENT ABSTRACTS OF JAPAN vol. 11, no. 231 (E-527) 28. Juli 1987 & JP-A-62 046 543
- PATENT ABSTRACTS OF JAPAN vol. 17, no. 431 (E-1411) 10. August 1993 & JP-A-05 090 261
- PATENT ABSTRACTS OF JAPAN vol. 15, no. 383 (E-1116) 27. September 1991 & JP-A-03 152 931
- PATENT ABSTRACTS OF JAPAN vol. 17, no. 125 (E-1332) 16. März 1993 & JP-A-04 299 846
- PATENT ABSTRACTS OF JAPAN vol. 16, no. 554 (E-1293) 25. November 1992 & JP-A-04 211 120

## Beschreibung

Die Planarisierung der Oberfläche eines Halbleiterschichtaufbaus gewinnt mit zunehmender Miniaturisierung mikroelektronischer Schaltungsstrukturen und mit dem zunehmenden Einsatz von Mehrlagenverdrahtungen an Bedeutung. Die verringerten Fokustiefen bei der Sub-µm Lithographie erfordern eine weitgehende Planarisierung der Oberfläche eines Halbleiterschichtaufbaus nach jedem Prozeßschritt. Unabhängig von diesen Lithographieproblemen ist eine Planarisierung der Oberfläche eines Halbleiterschichtaufbaus während der Prozeßführung vorteilhaft, da dadurch das Festsetzen von Lack oder anderen Materialresten an Ecken und Kanten vermieden wird.

In der Literatur hat sich der Begriff "Lokale Planarisierung" dafür eingebürgert, daß eine Planarität an der Oberfläche nur für bestimmte Strukturgrößen erfüllt ist. Wird die Planarität für alle Strukturen über die gesamte Oberfläche des Halbleiterschichtaufbaus erfüllt, so wird von "globaler Planarisierung" gesprochen.

Es ist bekannt, zur Planarisierung der Oberfläche eines Halbleiterschichtaufbaus eine Planarisierungsschicht aufzubringen, die durch Verfließen zu einem Ausgleichen der Unebenheiten in der Oberfläche führt (siehe zum Beispiel A. Nagy et al, Solid State Techn., Jan. 1991, pp. 53 bis 56). Die Planarisierungsschicht wird in der Regel auf eine isolierende Schicht, insbesondere eine Zwischenoxidschicht oder eine Passivierungsschicht, aufgebracht. Durch Rückätzen der Planarisierungsschicht wird die Oberfläche des Halbleiterschichtaufbaus für folgende Prozeßschritte vorbereitet. Die Planarisierungsschicht wird dabei maximal soweit rückgeätzt, daß die Oberfläche der isolierenden Schicht im Bereich der höchsten Strukturen freigelegt wird, Zwischenräume zwischen Strukturen dieser Höhe jedoch mit dem Material der Planarisierungsschicht aufgefüllt bleiben.

Bei diesem Verfahren hängt die erzielbare Planarisierung von der Verfließlänge des Lackes oder des Oxides der Planarisierungsschicht ab. Üblicherweise verwendete Lacke oder Oxide weisen Verfließlängen zwischen 10 µm und 200 µm auf. Umfaßt die Oberfläche, die planarisiert werden soll, größere Strukturen als die Verfließlänge, so erhöht sich die Dicke der Planarisierungsschicht auf größeren Strukturen, da nur im Bereich des Randes der Strukturen ein Ausgleichen durch Verfließen stattfindet. Diese Unebenheiten in der Planarisierungsschicht übertragen sich beim anschließenden Rückätzen in die Oberfläche.

Um derartige Unebenheiten zu vermeiden, ist vorgeschlagen worden (siehe zum Beispiel A. Nagy et al, Solid State Techn., Jan. 1991, pp. 53 bis 56 und V. Comello, 28/Semiconductor International, March 1990), vor dem Abscheiden der Planarisierungsschicht in größeren strukturfreien Gebieten Füllstrukturen zu erzeugen. Diese Füllstrukturen werden mit Hilfe einer zusätzlichen Phototechnik zum Beispiel aus Photolack hergestellt. Dadurch wird erreicht, daß zwischen den Strukturen nur kleine Zwischenräume vorhanden sind, die durch Verfließen aufgefüllt werden müssen. Durch Verkleinerung der Ausdehnung der Zwischenräume ist nur ein geringes Verfließen der Planarisierungsschicht erforderlich. Da gebräuchliche isolierende Schichten in der Regel mit mehr oder weniger konformer Kantenbedeckung abgeschieden werden, ist zur Herstellung der Füllstrukturen eine zusätzliche Maske notwendig, die auf die geometrische Anordnung der Strukturen und die Dicke der isolierenden Schicht angepaßt werden muß. Die Füllstrukturen müssen aus einem solchen Material gebildet werden, daß mit gleicher Ätzrate wie die isolierende Schicht ätzbar ist.

Ein anderes bekanntes Planarisierungsverfahren besteht im Polieren mit chemisch-mechanischem Abtrag, das auch als chemischmechanisches Polieren oder chemical mechanical polishing CMP bezeichnet wird und das zum Beispiel aus V. Comello, 28/Semiconductor International, March 1990 und Y. Hayashi et al, Ext. Abst. of Int. Conf. on Solid STate Dev. and Mat., Business Center for Acad. Soc. Japan, XXVIII, S. 533 bis 535, 1992, bekannt ist. Auf zu planarisierende Oberfläche wird dabei ein Poliermittel aufgebracht und mit einer Polierscheibe mechanisch poliert. Erhabene Strukturen kleinerer Ausdehnung werden dabei starker abgetragen als Strukturen größerer Ausdehnung (siehe Y. Hayashi et al, Ext. Abstr. of Int. Conf. on Solid STate Dev. and Mat., Business Center for Acad. Soc. Japan, XX-VIII, S. 533 bis 535, 1992). Bedingt durch die endliche Steifheit von Polierscheiben kommt es beim chemisch mechanischen Polieren in größeren strukturfreien Gebieten zu Einbuchtungen (siehe C. W. Kaanta et al, VMIC Conference IEEE, June 1991, pp. 144 bis 152). Um diese zu vermeiden wird in Y. Hayashi et al, Ext. Abst. of Int. Conf. on Solid State Dev. and Mat., Business Center for Acad. Soc. Japan, XXVIII, S. 533 bis 535, 1992, vorgeschlagen, zur Planarisierung zunächst eine Planarisierungsschicht aufzubringen, mit der durch Verschließen und Rückätzen eine Vorplanarisierung vorgenommen wird und dann durch chemisch mechanisches Polieren die endgültige globale Planarisierung zu erzielen.

Patent Abstract of Japan von JP-A-620 465 43 offenbart ein Verfahren zur Herstellung eines Halbleiterschichtaufbaus mit planarisierter Oberfläche gemäß dem Oberbegriff des Anspruchs 1.

Der Erfindung liegt das Problem zugrunde, ein Verfahren zur Herstellung eines Halbleiterschichtaufbaus mit planarisierter Oberfläche anzugeben, mit dem Unebenheiten im Bereich größerer Strukturen sowie größerer strukturfreier Gebiete vermieden werden. Das Verfahren soll insbesondere geeignet sein zum Einsatz bei der Herstellung eines Bipolartransistors sowie eines DRAM's.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird auf die Oberfläche eines Halbleiterschichtaufbaus, die Erhebungen mit einer Höhe bis zu einer maximalen Stufenhöhe aufweist, eine isolierende Schicht aufgebracht, deren Dicke größer ist als die maximale Strufenhöhe. Die isolierende Schicht wird anschließend so strukturiert, daß sie im Bereich der Kanten der Erhebungen Unebenheiten aufweist. Diese Unebenheiten haben eine im wesentlichen gleiche laterale Ausdehnung. Anschließend werden Unebenheiten durch chemisch mechanisches Polieren und/oder Abscheiden, Verfließen und Rückätzen einer Planarisierungsschicht planarisiert. Im erfindungsgemäßen Verfahren müssen nur diese Unebenheiten planarisiert werden. Die Ausdehnung der Unebenheiten ist unabhängig von der Größe der Erhebungen und dem Abstand zwischen benachbarten Erhebungen. Daher werden die Probleme, die sich in bekannten Verfahren bei der Planarisierung von Oberfläche mit größeren Strukturen und größeren strukturfreien Gebieten ergeben, vermieden.

Unter der isolierenden Schicht wird eine Stoppschicht, die mindestens an der Oberfläche Si₃/N₄ aufweist, mit im wesentlichen konformer Kantenbedeckung aufgebracht und auf die isolierende Schicht eine Hilfsschicht aus Polysilizium aufgebracht, wobei die isolierende Schicht sowohl zur Hilfsschicht als auch zur Stoppschicht selektiv ätzbar ist. In der Hilfsschicht werden oberhalb der Erhebungen Öffnungen erzeugt, die in ihrer Ausdehnung kleiner oder gleich der Ausdehnung der Erhebungen sind und in denen die Oberfläche der isolierenden Schicht freigelegt wird. Die Strukturierung der isolierenden Schicht erfolgt dann in einem isotropen Ätzprozeß selektiv zur Hilfsschicht und zur Stoppschicht. Nach Strukturierung der isolierenden Schicht wird die Hilfsschicht entfernt.

Vorzugsweise werden die Öffnungen in der Hilfsschicht mit Hilfe eines photolithographischen Verfahrens gebildet, wobei eine Zusatzmaske verwendet wird. Die Zusatzmaske weist im wesentlichen die gleichen Strukturen mit umgekehrtem Kontrast auf wie eine bei der Herstellung der Erhebungen verwendete Maske. Die Strukturen in der Zusatzmaske sind höchstens so groß wie diejenigen in der Maske. Es ist vorteilhaft, die Strukturen in der Zusatzmaske um einen der Justiertoleranz der Maske entsprechenden Vorhalt zu verkleinern.

Es liegt im Rahmen der Erfindung, den isotropen Ätzprozeß höchstens solange durchzuführen, bis innerhalb der Öffnungen die Oberfläche der Stoppschicht erreicht ist. Dabei entstehen an den Kanten der Erhebungen Spitzen, die über die Ebene der isolierenden Schicht hinausstehen. Diese können im nachfolgenden effektiv durch chemisch mechanisches Polieren planarisiert werden.

Gemäß einer anderen Ausführungsform der Erfindung wird der isotrope Ätzprozeß mindestens solange durchgeführt, bis eine Oxiddicke von dₒₓ = h + h/2 + D geätzt ist, wobei h die Dicke der isolierenden Schicht und D die Justiergenauigkeit ist, mit der die Öffnungen relativ zu den Erhebungen hergestellt sind. In diesem Fall ist die isolierende Schicht soweit zurückgeätzt, bis keine Spitzen der isolierenden Schicht über die maximale Stufenhöhe hinaus stehen bleiben. Da der isotrope Ätzprozeß selektiv zur Hilfsschicht und zur Stoppschicht angreift, bildet sich unter der Hilfsschicht eine Unterätzung.

Es liegt im Rahmen der Erfindung, nach Entfernen der Hilfsschicht ganzflächig eine weitere isolierende Schicht aufzubringen, die mit Hilfe von chemisch mechanischem Polieren und/oder durch Abscheiden, Verfließen und Rückätzen einer Planarisierungsschicht mit einer im wesentlichen planaren Oberfläche versehen wird. Auch in dieser Ausführungsform müssen lediglich Strukturen von der lateralen Ausdehnung der Unterätzung planarisiert werden.

Das Verfahren ist insbesondere geeignet zur Planarisierung der Oberfläche eines Halbleiterschichtaufbaus, in dem eine mikroelektronische Schaltung realisiert ist. Die mikroelektronische Schaltung ist insbesondere in einem Siliziumsubstrat oder einem SOI-Substrat realisiert. In diesem Fall ist die isolierende Schicht mindestens Teil einer Zwischenoxidschicht, die im wesentlichen aus SiO₂ besteht. Die Stoppschicht weist in diesem Fall mindestens an der Oberfläche Si₃N₄ auf. Vorzugsweise wird die Stoppschicht als Doppelschicht aus einer SiO₂-Schicht und einer Si₃N₄-Schicht gebildet. Die Hilfsschicht wird aus Polysilizium gebildet.

Das Verfahren ist vielfach anwendbar. Insbesondere ist es bei der Herstellung eines Bipolartransistors einsetzbar. Dabei wird nach Bildung der planaren Oberfläche in der isolierenden Schicht eine Öffnung auf einer Halbleiteroberfläche erzeugt, in der aktive Transistorgebiete durch selektive Epitaxie hergestellt werden.

Eine weitere vorteilhafte Anwendung besteht in der Herstellung eines DRAM mit Shallow Trench Isolation.

Im folgenden wird die Erfindung anhand der Figuren und eines Ausführungsbeispiels näher erläutert.
- Figur 1: zeigt einen Halbleiterschichtaufbau mit Erhebungen in der Oberfläche.
- Figur 2: zeigt den Halbleiterschichtaufbau nach Abscheiden einer Stoppschicht.
- Figur 3: zeigt den Halbleiterschichtaufbau nach Abscheiden einer isolierenden Schicht.
- Figur 4: zeigt den Halbleiterschichtaufbau nach Abscheiden einer Hilfsschicht.
- Figur 5: zeigt den Halbleiterschichtaufbau nach Strukturierung der isolierenden Schicht.
- Figur 6: zeigt den Halbleiterschichtaufbau nach Entfernen der Hilfsschicht.
- Figur 7: zeigt den Halbleiterschichtaufbau nach Aufbringen einer weiteren isolierenden Schicht und einer Planarisierungsschicht.
- Figur 8: zeigt den Halbleiterschichtaufbau nach Rückätzen der Planarisierungsschicht.
- Figur 9: zeigt eine weitere Ausführungsform der Strukturierung der isolierenden Schicht.
- Figur 10: zeigt einen Halbleiterschichtaufbau mit einer isolierenden Schicht, deren Oberfläche planarisiert wurde, in dem durch selektive Epitaxie ein aktives Transistorgebiet für einen Bipolartransistor gebildet wurde.
- Figur 11: zeigt einen Halbleiterschichtaufbau, der eine DRAM-Anordnung mit Shallow Trench Isolation umfaßt.

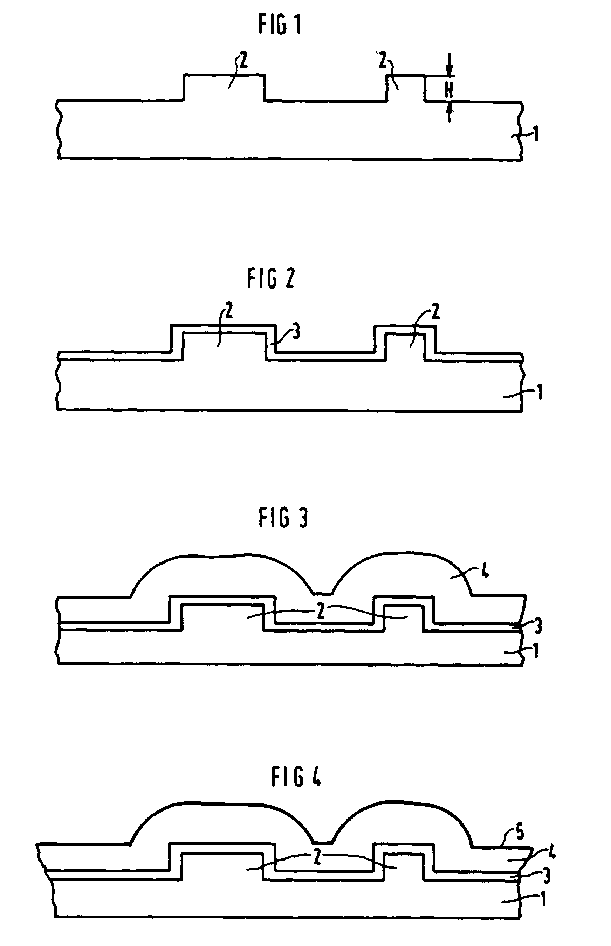

Ein Halbleiterschichtaufbau 1 weist an der Oberfläche Erhebungen 2 auf (siehe Figur 1). Der Halbleiterschichtaufbau 1 ist zum Beispiel ein Siliziumsubstrat mit Strukturen für eine integrierte Schaltung oder ein SOI-Substrat mit Strukturen für eine integrierte Schaltung. Die Erhebungen 2 weisen eine maximale Stufenhöhe H auf. Die Stufenhöhe der Erhebungen 2 liegen im Bereich zwischen 0,1 und 1 µm.

Auf die Oberfläche des Halbleiterschichtaufbaus 1 wird ganzflächig eine Stoppschicht 3 aufgebracht (siehe Figur 2). Die Stoppschicht 3 wird zum Beispiel aus einer SiO₂-Schicht in einer Dicke von zum Beispiel 10 nm, die durch thermische Oxidation gebildet wird und einer darauf abgeschiedenen Si₃N₄-Schicht mit einer Dicke von zum Beispiel 100 nm gebildet. Die Stoppschicht 3 wird im wesentlichen mit konformer Kantenbedeckung hergestellt.

Es wird ganzflächig eine isolierende Schicht 4 abgeschieden (siehe Figur 3). Die isolierende Schicht 4 wird zum Beispiel durch Abscheidung in einem TEOS-Verfahren von SiO₂ oder durch Abscheidung von Borsilikatglas gebildet. Die Dicke der isolierenden Schicht 4 ist mindestens so groß wie die maximale Stufenhöhe der Erhebungen 2. Die isolierende Schicht 4 wird zum Beispiel in einer Dicke von 1,5 µm abgeschieden.

Auf die isolierende Schicht 4 wird ganzflächig eine Hilfsschicht 5 aufgebracht aus einem Material, das selektiv sowohl zu dem Material der isolierenden Schicht als auch zu dem Material der Stoppschicht ätzbar ist. Die Selektivität muß sowohl für naßchemische als auch für Trockenätzprozesse gelten. Die Hilfsschicht 5 (siehe Figur 4) wird aus Polysilizium zum Beispiel in einer Dicke von 20 bis 100 nm gebildet.

Die Hilfsschicht 5 wird unter Verwendung einer Zusatzmaske strukturiert. Die Zusatzmaske weist im wesentlichen die gleichen Strukturen mit umgekehrtem Kontrast auf wie eine zur Herstellung der Erhebungen 2 verwendete Maske. Der Maskenvorhalt der Zusatzmaske wird so gewählt, daß unter Verwendung der Zusatzmaske in die Hilfsschicht 5 geöffnete Öffnungen 6 in lateraler Richtung, das heißt parallel zur Oberfläche des Halbleiterschichtaufbaus, höchstens die gleiche Ausdehnung wie die Erhebungen 2 aufweisen. Die Zusatzmaske wird mit einer typischen Justiertolereanz von +/- 100 nm justiert. Daher ist es zweckmäßig die Strukturen in der Zusatzmaske in Breite und Länge um diesen Betrag im Vergleich zu den Strukturen in der ursprünglichen Maske zu verkleinern.

Die Herstellung der Öffnungen 6 in der Hilfsschicht 5 erfolgt zum Beispiel durch negatives Ionenätzen.

Unter Verwendung der strukturierten Hilfsschicht 5 als Ätzmaske wird anschließend eine isotrope Ätzung unter Verwendung von einer verdünnten Lösung aus HF und Wasser im Verhältnis von zum Beispiel 1 : 10 durchgeführt. Die isotrope Ätzung greift die isolierende Schicht 4 selektiv zur Hilfsschicht 5 und zur darunterliegenden Stoppschicht 3 an.

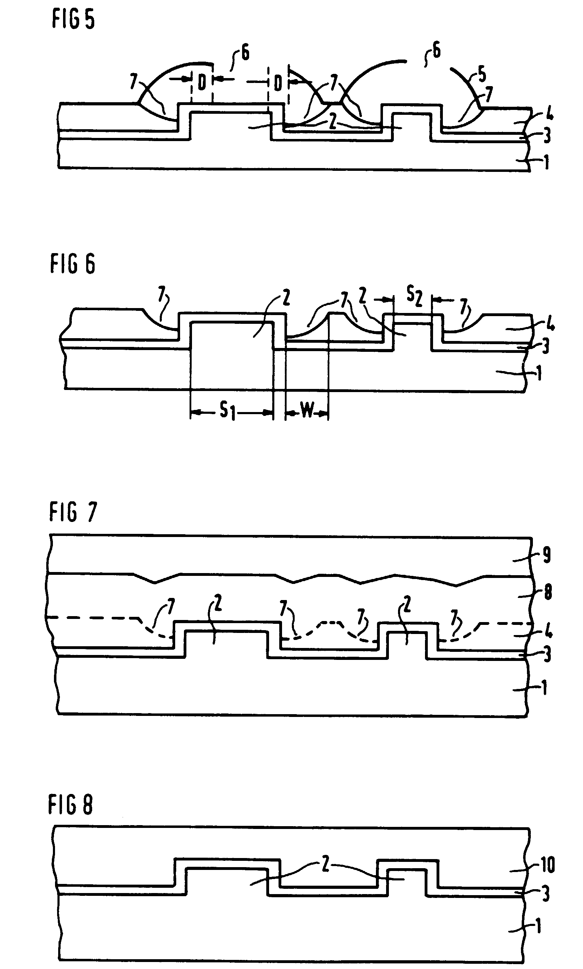

Die Ätzung wird solange fortgesetzt, bis eine Gesamtoxiddicke dₒₓ = h + h/2 + D geätzt worden sind. Dabei ist h die Dicke der isolierenden Schicht 4, und D die Dejustierung der Kanten der Öffnungen 6 in der Hilfsschicht 5 von den Kanten der Erhebungen 2 (siehe Figur 5). Bei diesem Ätzschritt entstehen seitlich der Erhebungen 2 in der isolierenden Schicht 4 Unebenheiten 7. Im Bereich der Unebenheiten 7 ist die effektive Dicke der isolierenden Schicht 4 geringer als die maximale Stufenhöhe der Erhebungen 2.

Um sicherzugehen, daß keine Spitzen der isolierenden Schicht 4 nach der isotropen Ätzung über die maximale Stufenhöhe hinausragen, wird für die Dejustierung D die doppelte Justiertoleranz von typisch +/- 100 nm, das heißt 200 nm, angesetzt.

Figur 6 zeigt den Halbleiterschichtaufbau 1 nach Entfernen der Hilfsschicht 5. Die isolierende Schicht 4 schließt nach der Strukturierung in der Höhe im wesentlichen mit den Erhebungen 2 ab. Sie weist die Unebenheiten 7 auf, in denen die Dicke der isolierenden Schicht 4 reduziert ist. Die laterale Ausdehnung W der Unebenheiten 7 hängt von der Dauer des isotropen Ätzprozesses und der Dejustierung der Öffnungen 6 relativ zu den Erhebungen 2 ab. Die laterale Ausdehnung W ist insbesondere unabhängig von der lateralen Strukturgröße S₁, S₂ der Erhebungen 2. In nachfolgenden Planarisierungsprozessen brauchen daher nur die Unebenheiten 7, die im wesentlichen die gleiche konstante laterale Ausdehnung W aufweisen, planarisiert werden, unabhängig von den lateralen Strukturgrößen S₁, S₂ der Erhebungen 2.

Anschließend wird eine weitere isolierende Schicht 8 zum Beispiel durch Abscheidung von SiO₂ in einem TEOS-Verfahren aufgebracht (siehe Figur 7). Die weitere isolierende Schicht 8 weist eine unebene Oberfläche auf, die durch die Unebenheiten 7 in der isolierenden Schicht 4 bedingt sind.

Auf die weitere isolierende Schicht 8 wird eine Planarisierungsschicht 9 aufgebracht. Die Planarisierungsschicht 9 wird zum Beispiel aus Lack gebildet. Durch Verfließen gleicht die Planarisierungsschicht 9 die unebene Oberfläche der weiteren isolierenden Schicht 8 aus und weist selber eine planare Oberfläche auf (siehe Figur 7).

Durch Rückätzen zum Beispiel in einem Trockenätzprozeß entsteht eine planarisierte isolierende Schicht 10 (siehe Figur 8). Das Ausmaß der Rückätzung und damit die Dicke der planarisierten isolierenden Schicht 10 wird entsprechend der jeweiligen Anwendung eingestellt.

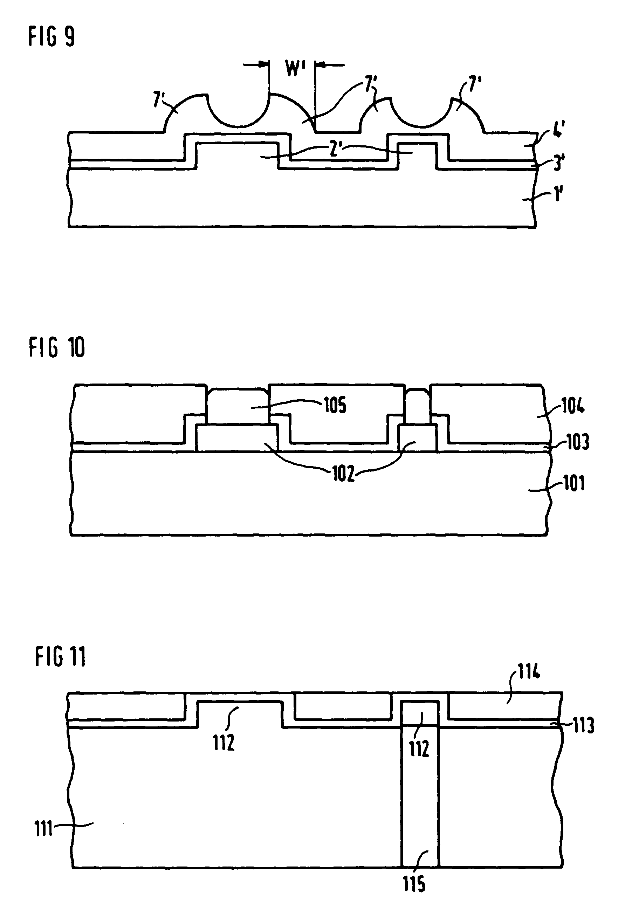

Figur 9 zeigt einen Halbleiterschichtaufbau 1' mit Erhebungen 2' mit einer maximalen Stufenhöhe. Auf der Oberfläche des Halbleiterschichtaufbaus 1' ist eine strukturierte isolierende Schicht 4' angeordnet. Die isolierende Schicht 4' weist im Bereich der Kanten der Erhebungen 2' Unebenheiten 7' auf, die über die maximale Stufenhöhe hinausragen. Die in Figur 9 dargestellte Struktur ergibt sich, wenn bei dem isotropen Ätzprozeß, der anhand von Figur 5 erläutert wurde, die Ätzung nur solange durchgeführt wird, bis eine Oxiddicke entsprechend der Dicke der isolierenden Schicht 4' geätzt ist. Die Unebenheiten 7' der isolierenden Schicht 4' weisen eine laterale Ausdehnung W' auf, die von der Justiergenauigkeit der Zusatzmaske und von der Dicke der isolierenden Schicht 4' abhängt. Die Unebenheiten 7' sind im Bereich der Ränder der Unebenheiten 2' angeordnet. Ihre laterale Ausdehnung ist unabhängig von der lateralen Strukturgröße der Unebenheiten 2'. Die über die Ebene der isolierenden Schicht 4' hinausragenden Unebenheiten 7' werden vorzugsweise durch chemisch mechanisches Polieren planarisiert. Bei Freilegen der Oberfläche der Stoppschicht 3' im Bereich der Erhebungen 2' wird das chemisch mechanische Polieren beendet.

Anhand von Figur 10 wird die Anwendung des erfindungsgemäßen Verfahrens bei der Bipolarherstellung erläutert. Ein Halbleiterschichtaufbau 101 ist mit Erhebungen 102 aus einkristallinem Silizium versehen. Die Erhebungen 102 sind als vergrabene Schichten zum Anschluß eines Kollektors eines Bipolartransistors vorgesehen. Die Oberfläche des Halbleiterschichtaufbaus 101 und der Erhebungen 102 ist mit einer Stoppschicht 103 bedeckt. Auf der Stoppschicht 103 ist eine isolierende Schicht 104 angeordnet, deren Oberfläche mit Hilfe des erfindungsgemäßen Verfahrens planarisiert ist. In der isolierenden Schicht 104 werden Öffnungen erzeugt, in denen die Oberfläche der Erhebungen 102 freigelegt wird. Auf der Oberfläche der Erhebungen 102 wird durch selektive Epitaxie ein einkristallines Gebiet 105 erzeugt, das als Kollektor und/oder aktives Gebiet eines Bipolartransistors verwendet werden kann. Die isolierende Schicht 104 wird in diesem Beispiel in einer Dicke von 200 bis 600 nm erzeugt.

Eine weitere Anwendungsmöglichkeit des erfindungsgemäßen Verfahrens besteht in der Herstellung einer sogenannten Shallow Trench Isolation für DRAM's. Die Shallow Trench Isolation ist zum Beispiel aus V. Comello, 28/Semiconductor International, March 1990, bekannt. Dabei werden aktive Transistorgebiete und Speicherknoten, die im wesentlichen in einer Ebene der Schaltung angeordnet sind, durch flache Gräben, die mit einer Isolation gefüllt werden, voneinander isoliert. Ein Halbleiterschichtaufbau 111 (siehe Figur 11) weist dann als Erhebungen 112 ein aktives Transistorsgebiet und einen Speicherknoten auf. Der Speicherknoten ist oberhalb eines in einem Graben angeordneten Speicherkondensators 115 angeordnet. Die Oberfläche des Halbleiterschichtaufbaus 111 und der Erhebungen 112 ist mit einer Stoppschicht 113 versehen. Darauf wird nach dem erfindungsgemäßen Verfahren eine planarisierte isolierende Schicht 114 hergestellt. Die isolierende Schicht 114 wird so planarisiert, daß oberhalb der Erhebungen 112 die Oberfläche der Stoppschicht 113 freigelegt ist.

Der Speicherknoten, auch als Trenchnode bezeichnet, wird zum Auslesen des Speicherkondensators verwendet. Ein Auswahl MOS-Transistor ist im aktiven Transistorgebiet untergebracht. Eine Zuleitung zwischen Speicherknoten und aktivem Transistorgebiet ist in dem Schnitt von Figur 11 nicht sichtbar. Die Shallow Trench Isolation dient dazu, alle Auswahltransistoren lateral des in Figur 11 gezeigten im Graben angeordneten Speicherkondensators zu isolieren. Ebenso werden alle anderen Speicherkondensatoren und Transistoren untereinander isoliert. Die Isolation zum Substrat erfolgt über einen hier nicht eingezeichneten pn-Übergang oder durch SOI-Isolation.

## Patentansprüche

1. Verfahren zur Herstellung eines Halbleiterschichtaufbaus mit planarisierter Oberfläche,
- bei dem auf die Oberfläche des Halbleiterschichtaufbaus (1, 1'), die Erhebungen (2, 2') mit einer Höhe bis zu einer maximalen Stufenhöhe aufweist, eine Stoppschicht (3, 3'), eine isolierende Schicht (4, 4') und eine Hilfsschicht (5, 5') aufgebracht werden,
- bei dem die Dicke der isolierenden Schicht (4, 4') größer als die maximale Stufenhöhe ist,
- bei dem die Stoppschicht (3, 3') mit im wesentlichen konformer Kantenbedeckung aufgebracht wird,
- bei dem die isolierende Schicht (4, 4') sowohl zur Hilfsschicht (5, 5') als auch zur Stoppschicht (3, 3') selektiv ätzbar ist,
- bei dem in der Hilfsschicht (5, 5') oberhalb der Erhebungen (2, 2') Öffnungen (6) erzeugt werden, deren Ausdehnung kleiner oder gleich der lateralen Ausdehnung der Erhebungen (2, 2') sind und in denen die Oberfläche der isolierenden Schicht (4, 4') freigelegt wird,
- bei dem die isolierende Schicht (4, 4') in einem isotropen Ätzprozeß selektiv zur Hilfsschicht (5) und zur Stoppschicht (3, 3') so strukturiert wird, daß sie im Bereich der Kanten der Erhebungen (2, 2') Unebenheiten (7, 7') im wesentlichen gleicher lateraler Ausdehnung aufweist,
- bei dem nach Strukturierung der isolierenden Schicht (4, 4') die Hilfsschicht (5) entfernt wird,
- bei dem die Unebenheiten (7, 7') durch chemischmechanisches Polieren und/oder Abscheiden, Verfließen und Rückätzen einer Planarisierungsschicht (9) planarisiert werden,
dadurch gekennzeichnet, daß die Stoppschicht mindestens an der Oberfläche Si₃N₄ aufweist und die Hilfsschicht aus Polysilizium gebildet wird.

2. Verfahren nach Anspruch 1,
- bei dem die Öffnungen (6) in der Hilfsschicht (5) mit Hilfe eines photolithographischen Verfahrens unter Verwendung einer Zusatzmaske gebildet werden,
- bei dem die Zusatzmaske im wesentlichen die gleichen Strukturen mit umgekehrtem Kontrast aufweist wie eine zur Herstellung der Erhebungen (2, 2') verwendete Maske.

3. Verfahren nach Anspruch 1 oder 2,
bei dem der isotrope Ätzprozeß höchstens solange durchgeführt wird, bis innerhalb der Öffnungen die Oberfläche der Stoppschicht erreicht ist.

4. Verfahren nach Anspruch 1 oder 2,
bei dem der isotrope Ätzprozeß mindestens solange durchgeführt wird, bis eine Materialdicke von dₒₓ = h + h/2 + D geätzt ist, wobei h die Dicke der isolierenden Schicht (4) und D die Dejustage ist, mit der die Öffnungen (6) relativ zu den Erhebungen (2) hergestellt sind.

5. Verfahren nach Anspruch 4,
bei dem nach Entfernen der Hilfsschicht (5) ganzflächig eine weitere isolierende Schicht (8) aufgebracht wird, die mit Hilfe von chemisch mechanischem Polieren und/oder durch Abscheiden, Verfließen und Rückätzen einer Planarisierungsschicht (9) mit einer im wesentlichen planaren Oberfläche versehen wird.

6. Verfahren nach einem der Ansprüche 1 bis 5,
bei dem die isolierende Schicht (4) eine Zwischenoxidschicht ist und bei dem der Halbleiterschichtaufbau eine auf Siliziumbasis realsierte integrierte Schaltung umfaßt.

7. Verwendung eines Verfahrens nach einem der Ansprüche 1 bis 6
bei der Herstellung eines Bipolartransistors, wobei nach Bildung der planaren Oberfläche in der isolierenden Schicht (104) eine Öffnung auf einer Halbleiteroberfläche erzeugt wird, in der aktive Transistorgebiete (105) durch selektive Epitaxie hergestellt werden.

8. Verwendung eines Verfahrens nach einem der Ansprüche 1 bis 6
bei der Herstellung eines DRAM's mit Shallow-Trench-Isolation.

## Claims

1. Process for producing a semiconductor layer structure having a planarized surface,
- in which a stop layer (3, 3'), an insulating layer (4, 4') and an auxiliary layer (5, 5') are applied to the surface of the semiconductor layer structure (1, 1'), which surface has elevations (2, 2') having a height up to a maximum step height,
- in which the thickness of the insulating layer (4, 4') is greater than the maximum step height,
- in which the stop layer (3, 3') is applied with essentially conformal edge covering,
- in which the insulating layer (4, 4') can be selectively etched both with respect to the auxiliary layer (5, 5') and with respect to the stop layer (3, 3'),
- in which openings (6) whose extent is less than or equal to the lateral extent of the elevations (2, 2') and in which the surface of the insulating layer (4, 4') is exposed are produced in the auxiliary layer (5, 5') above the elevations (2, 2'),
- in which the insulating layer (4, 4') is structured in an isotropic etching process selectively with respect to the auxiliary layer (5) and with respect to the stop layer (3, 3') in such a way that it has unevennesses (7, 7') having an essentially identical lateral extent in the region of the edges of the elevations (2, 2'),
- in which the auxiliary layer (5) is removed following the structuring of the insulating layer (4, 4'), - in which the unevennesses (7, 7') are planarized by chemical mechanical polishing and/or deposition, flowing and etching back of a planarization layer (9),
characterized in that the stop layer has Si₃N₄ at least at its surface and the auxiliary layer is formed from polysilicon.

2. Method according to Claim 1,
- in which the openings (6) in the auxiliary layer (5) are formed with the aid of a photolithographic process using an additional mask,
- in which the additional mask has essentially the same structures with inverse contrast as a mask used for producing the elevations (2, 2').

3. Method according to Claim 1 or 2,
in which the isotropic etching process is carried out at most until the surface of the stop layer is reached inside the openings.

4. Process according to Claim 1 or 2,
in which the isotropic etching process is carried out at least until a material thickness of dₒₓ = h + h/2 + D has been etched, where h is the thickness of the insulation layer (4) and D is the out-of-alignment with which the openings (6) are produced relative to the elevations (2).

5. Process according to Claim 4,
in which the removal of the auxiliary layer (5) is followed by whole-area application of a further insulating layer (8), which is provided with an essentially planar surface with the aid of chemical mechanical polishing and/or by deposition, flowing and etching back a planarization layer (9).

6. Process according to one of Claims 1 to 5,
in which the insulating layer (4) is an intermediate oxide layer and in which the semiconductor layer structure comprises an insulated circuit realised on a silicon base.

7. Use of a process according to one of Claims 1 to 6
in the production of a bipolar transistor, wherein an opening onto a semiconductor surface is produced in the insulating layer (104) after the formation of the planar surface, in which opening active transistor regions (105) are produced by selective epitaxy.

8. Use of a process according to one of Claims 1 to 6
in the production of a DRAM with shallow trench insulation.

## Revendications

1. Procédé de fabrication d'une structure stratifiée semi-conductrice comportant une surface rendue planar, au cours duquel :
- sur la surface de la structure stratifiée semi-condrice (1, 1'), qui comporte des parties surélevées (2, 2') présentant une hauteur allant jusqu'à une hauteur maximale de gradin, sont appliquées une couche d'arrêt (3, 3'), une couche isolante (4, 4') et une couche auxiliaire (5, 5'),
- l'épaisseur de la couche isolante (4, 4') est plus grande que la hauteur maximale de gradin,
- la couche d'arrêt (3, 3') est appliquée avec un recouvrement de côtés essentiellement conforme,
- la couche isolante (4, 4') peut être décapée sélectivement aussi bien par rapport à la couche auxiliaire (5, 5') que par rapport à la couche d'arrêt (3, 3'),
- dans la couche auxiliaire (5, 5'), au-dessus des parties surélevées (2, 2'), sont pratiquées des ouvertures (6), dont l'étendue est inférieure ou égale à l'étendue latérale des parties surélevées (2, 2') et dans lesquelles la surface supérieure de la couche isolante (4, 4') est mise à nu;
- la couche isolante (4, 4') est structurée au cours d'une opération de décapage isotrope, sélectivement par rapport à la couche auxiliaire (5) et par rapport à la couche d'arrêt (3, 3'), de telle façon qu'elle présente, dans la zone des côtés des parties surélevées (2, 2'), des défauts de planéité (7, 7') une étendue latérale essentiellement égale,
- après structuration de la couche isolante (4, 4'), on enlève la couche auxiliaire (5),
- les défauts de planéité (7, 7') sont rendus planar par polissage chimico-mécanique et/ou dépôt, coulage et redécapage d'une couche de planarisation (9),
caractérisé en ce que la couche d'arrêt présente du Si₃N₄ au moins à la surface et en ce que la couche auxiliaire est formée de polysilicium.

2. Procédé suivant la revendication 1, au cours duquel :
- les ouvertures dans la couche auxiliaire (5) sont réalisées à l'aide d'un procédé photolithographique en utilisant un masque auxiliaire, et
- le masque auxiliaire présente essentiellement les mêmes structures avec un contraste inversé par rapport à un masque utilisé pour la réalisation des parties surélevées (2, 2').

3. Procédé suivant la revendication 1 ou la revendication 2, au cours duquel l'opération de décapage est poursuivie au moins jusqu'à ce qu'à l'intérieur des ouvertures, soit atteinte la surface de la couche d'arrêt.

4. Procédé suivant la revendication 1 ou la revendication 2, au cours duquel l'opération de décapage est poursuivie au moins jusqu'à ce que soit atteinte une épaisseur de matériau dₒₓ = h + h/2 + D, h étant l'épaisseur de la couche isolante (4) et D le degré de décalage avec lequel sont réalisées les ouvertures (6) par rapport aux parties surélevées (2).

5. Procédé suivant la revendication 4, au cours duquel, après enlèvement de la couche auxiliaire (5), est appliquée, sur toute la surface, une autre couche isolante (8) qui est munie d'une surface essentiellement planar à l'aide d'un polissage chimico-mécanique et/ou dépôt, coulage et redécapage d'une couche de planarisation (9).

6. Procédé suivant l'une des revendications 1 à 5, au cours duquel la couche isolante (4) est une couche intermédiaire d'oxyde et la structure stratifiée semi-conductrice comprend un circuit intégré réalisé sur un substrat de silicium.

7. Utilisation d'un procédé suivant l'une des revendications 1 à 6,
pour la fabrication d'un transistor bipolaire, une ouverture étant pratiquée sur une surface semi-conductrice après réalisation de la surface planar dans la couche isolante (104), ouverture dans laquelle des zones actives de transistor (105) sont réalisées par épitaxie sélective.

8. Utilisation d'un procédé suivant l'une des revendications 1 à 6,
pour la fabrication d'une mémoire RAM dynamique comportant une isolation à tranchée de faible profondeur.
